Europäisches Patentamt

European Patent Office

Office européen des brevets

(19)

(11) **EP 0 546 919 B1**

(12) **FASCICULE DE BREVET EUROPEEN**

(45) Date de publication et mention
de la délivrance du brevet:
**16.04.1997 Bulletin 1997/16**

(51) Int Cl.6: **H01L 27/02**, H01L 29/73

(21) Numéro de dépôt: **92403314.5**

(22) Date de dépôt: **08.12.1992**

(54) **Transistor bipolaire à hétérojonction insensible à la variation de la température extérieure et circuit intégré associé**

Heteroübergang-Bipolartransistor, der für Aussertemperaturvariation unempfindlich ist und zugehörige integrierte Schaltung

Heterojunction bipolar transistor insensitive to external temperature variation and associated integrated circuit

(84) Etats contractants désignés:
**DE GB**

(30) Priorité: **11.12.1991 FR 9115342**

(43) Date de publication de la demande:
**16.06.1993 Bulletin 1993/24**

(73) Titulaire: **FRANCE TELECOM**
**75015 Paris (FR)**

(72) Inventeur: **Wang, Haila**
**F-92160 Antony (FR)**

(74) Mandataire: **Signore, Robert et al**
**c/o SOCIETE DE PROTECTION DES INVENTIONS**
**25, rue de Ponthieu**
**75008 Paris (FR)**

(56) Documents cités:
**EP-A- 0 021 907**

- **EXTENDED ABSTRACTS OF THE 16TH CONFERENCE ON SOLID STATE DEVICES AND MATERIALS 1984, KOBE pages 351 - 354 H.ITO ET AL. 'HIGH CURRENT GAIN ALGAAS/GAAS HETEROJUNCTION BIPOLAR TRANSISTORS WITH HEAVILY DOPED BASE'**
- **High Speed Semiconductor Devices,S.M.Sze,John Wiley and Sons, 1990,pages 381-383**

## Description

La présente invention concerne un transistor bipolaire à hétérojonction insensible à la variation de la température extérieure. Elle concerne aussi un circuit intégré associé utilisant, comme élément actif un tel transistor.

Dans les applications hyperfréquences, analogiques ou numériques, la température extérieure de fonctionnement des circuits peut varier au cours du temps d'une façon qui affecte les circuits principalement au niveau des jonctions semiconductrices. A titre d'exemple, on peut citer l'influence de la température extérieure sur les circuits hyperfréquences dans un satellite de télécommunications, sur les circuits d'émission et de réception dans un radiotéléphone portable ou encore sur les circuits dans un ordinateur personnel. Dans le cas d'un satellite artificiel, par exemple, la température extérieure change selon la position orbitale, l'exposition au soleil, etc.

Or, les caractéristiques électriques des transistors changent en fonction de la température. Un changement de température extérieure entraîne donc un changement dans le point de fonctionnement du transistor.

D'autre part, un type particulier de transistor a pris un grand développement ces dernières années dans les applications où un fort gain était demandé même à des fréquences très élevées ou sous des dimensions réduites (microminiaturisation). Ce transistor bipolaire, dit à hétérojonction (en abrégé TBH), travaille fondamentalement sur la base d'un empilement de matériaux semiconducteurs composites du groupe III- V dont au moins le contenu en aluminium varie entre plusieurs couches, elles- mêmes dopées par des impuretés. Les teneurs en composés comme GaAs et GaAlAs peuvent présenter une gradualité selon des profils adaptés pour améliorer le comportement fréquentiel du transistor.

Ainsi, on connaît un transistor bipolaire à hétérojonction constitué par un empilement de couches :

- un substrat GaAs
- une couche de contact de collecteur GaAs dopé n+ ;
- un collecteur GaAs dopé n- ;
- une base GaAs dopé p+ ;
- une couche d'interface d'émetteur $Ga_{1-x}Al_xAs$ avec gradation de x de 0 à 0,3 depuis la base vers l'émetteur ;
- un émetteur $Ga_{1-x}Al_xAs$, avec x = 0,3 et dopé n ;
- une couche d'interface d'émetteur $Ga_{1-x}Al_xAs$ avec gradation de x de 0,3 à 0 depuis l'émetteur vers une couche de contact d'émetteur ;
- une couche de contact d'émetteur GaAs dopée n+.

Quand on exécute une modélisation du fonctionnement électrique d'un tel dispositif, on établit des équations entre les tensions et les courants sur les différentes électrodes accessibles du dispositif. Ainsi, en polarisation en émetteur commun, les caractéristiques du TBH sont de la forme :

$$V_{BE} = f1(I_B, I_C) \qquad (1)$$

$$V_{CE} = f2(I_B, I_C) \qquad (2)$$

en désignant par $V_{BE}$, la tension entre la base et l'émetteur, par $V_{CE}$, la tension entre l'émetteur et le collecteur et par $I_B$ ou $I_C$ les courants entrants ou sortants par l'électrode de base ou de collecteur, respectivement.

Or, de tels transistors présentent des dérives par rapport à leurs caractéristiques quand la température extérieure Te varie.

En fait, les caractéristiques du dispositif sont de la forme :

$$V_{BE} = f1(I_B, I_C, Te) \qquad (3)$$

$$V_{CE} = f2(I_B, I_C, Te) \qquad (4)$$

Quand Te varie, comme la résistance thermique Rth du dispositif est donnée par une relation du genre :

$$Rth = (Tj - Te)/ Pd \qquad (5)$$

$$Pd = V_{CE} \cdot I_C + V_{BE} \cdot I_B \qquad (6)$$

où Tj est la température de jonction et Pd est la puissance dissipée, on conçoit que les caractéristiques électriques du dispositif changent, ce qui introduit des disfonctionnements.

C'est un objet de l'invention de porter remède à cet inconvénient de l'art antérieur.

La température extérieure Te de fonctionnement, qui est identique à la température ambiante Ta, et la température de jonction Tj d'un transistor sont liées par la relation (5). Or, la température Tj a une influence directe sur le comportement des transistors. On dit qu'un transistor est insensible à la température extérieure de fonctionnement Ta si les courants et les tensions du transistor restent constants lorsque la température ambiante Ta varie. Pour ce type de transistor, comme la puissance dissipée reste constante (voir équation 6), une variation de Ta entraîne une variation de la température Tj, et réciproquement (voir équation 5). Donc, un transistor insensible à la température extérieure est un transistor insensible à la température de jonction et réciproquement.

Or, il est déjà connu de corriger les comportements en température des transistors d'autres types. Mais, les comportements des transistors sont différents selon le type de transistor étudié.

Pour un transistor à effet de champ, le courant de drain dépend essentiellement de la mobilité et de la vitesse de saturation des porteurs. Ainsi, quand la température des jonctions Tj augmente, la mobilité et la vitesse de saturation des porteurs diminue. Par conséquent, le courant diminue et la puissance dissipée Pd diminue également. Donc, le transistor à effet de champ est thermiquement stable mais son comportement varie sensiblement avec la température extérieure.

Pour un transistor bipolaire à homojonction, c'est-à-dire un transistor dont les jonctions sont obtenues dans un semi-conducteur unique, le comportement thermique est très différent. En effet, le courant de collecteur augmente lorsque la température Tj augmente et le gain du transistor augmente aussi. Par conséquent, si la température Tj augmente , le courant de collecteur et la puissance dissipée Pd augmentent aussi. De ce fait, on remarque que, plus la température ambiante augmente, plus la température Tj augmente et donc la puissance dissipée et le courant aussi. De ce fait, le processus peut éventuellement diverger, et dans ce cas, un claquage peut apparaître, entraînant la destruction du transistor.

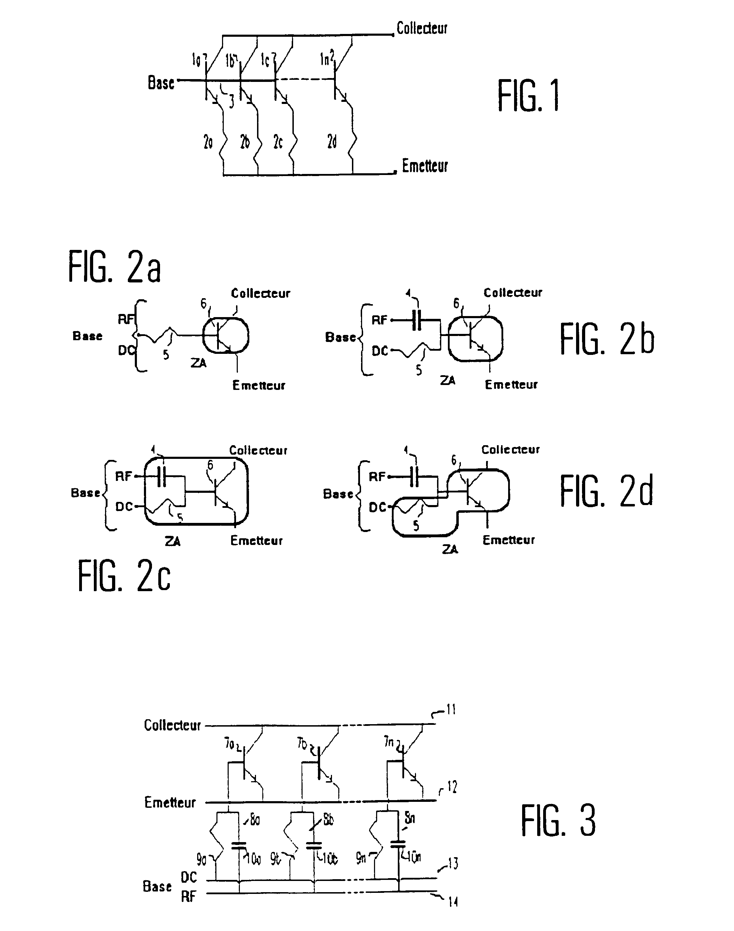

Pour pallier à ces claquages, on utilise des résistances de stabilisation, dites aussi résistances ballast, placées sur chaque doigt d'émetteur interdigité comme il est représenté à la figure 1. Pour une valeur suffisamment grande de cette résistance, le processus décrit précédemment converge vers une température stabilisée. Mais, dans ce cas, même avec des résistances ballast, les caractéristiques,du transistor varient en fonction de la température extérieure.

En ce qui concerne le transistor bipolaire à hétérojonction TBH, la situation est plus complexe que pour le transistor homojonction, Dans l'article de ITO et alt., "High current gain AlGaAs/GaAs Heterojunction Bipolar Transistors with heavily doped base", Extended Abstracts of the 16th International Conference on Solid State Devices and Materials ; Kobé, 1984, pp 351- 354, on a décrit des expérimentations menées à partir d'une modélisation du transistor bipolaire à hétérojonction, à $V_{BC}$ nul. La caractéristique de cette jonction a fait apparaître une dépendance du gain en courant $i_c/i_b$ en fonction de la température de jonction. En effet, le courant de saturation du collecteur Ic0 augmente en fonction de la température Tj de jonction comme dans le cas des transistors bipolaires à homojonction au silicium. Mais, à l'inverse, le gain du transistor bipolaire à hétérojonction diminue en fonction de cette température quand la température est supérieure à environ -50°C. Dans le cas des transistors à fort dopage de base, ceci est dû à la décroissance de la durée de vie des porteurs dans la base. Dans le cas des transistors à moyen ou faible dopage de base, c'est la différence de largeur de bande interdite entre l'émetteur et la base qui entre en jeu.

De ce fait, le comportement des transistors bipolaires à hétérojonction varie aussi en fonction de la température extérieure. De plus, ils sont aussi instables thermiquement que les transistors bipolaires classiques, si on les utilise sans précaution.

Dans l'art antérieur, on sait réaliser, à l'aide d'un dispositif de contrôle extérieur, la mesure d'un paramètre dépendant du comportement thermique du transistor. La grandeur de mesure rétro- agit sur la polarisation du circuit par le biais des circuits de contrôle extérieurs aux transistors. De ce fait, on constitue une boucle de rétroaction qui, en général, est coûteuse et complexe. Aucune technique efficace n'existe pour compenser une variation au niveau du transistor lui-même.

C'est un premier objet de l'invention de fournir un transistor bipolaire à hétérojonction dont le comportement est indépendant de la température extérieure.

C'est un second objet de l'invention de fournir un transistor bipolaire à hétérojonction dont le fonctionnement est thermiquement stable.

C'est un troisième objet de l'invention de fournir un transistor bipolaire à hétérojonction stable thermiquement et à comportement indépendant de la température ambiante, sans que son comportement électrique fréquentiel soit perturbé.

En effet, l'invention concerne un transistor bipolaire à hétérojonction, tel que défini par la revendication 1.

Selon l'invention, le dispositif de stabilisation est placé sur la base et est très simple. Dans un mode de réalisation, la résistance du dispositif de stabilisation est interne au transistor TBH, tandis que d'autres éléments sont disposés à l'extérieur de la zone active du circuit intégré ou du substrat sur lequel on réalise le transistor. Dans d'autres modes de réalisation où les condensateurs à prévoir sont de faibles valeurs, l'ensemble du dispositif de stabilisation est interne à la zone active du transistor.

En fait, un transistor compensé en température de façon interne et insensible à la températeure extérieure, permet de concevoir et de réaliser des circuits intégrés sur la base de ce transistor sans se soucier du comportement du circuit vis à vis de la température extérieure. Ceci n'est pas le cas des circuits actuels qui utilisent pourtant des circuits de contrôle pour rendre stable le fonctionnement.

C'est un avantage de l'invention de proposer un moyen évitant d'avoir à utiliser un dispositif complexe pour tenir compte de cette température extérieure de fonctionnement lors de la conception d'un circuit intégré utilisant au moins un transistor bipolaire à hétérojonction selon l'invention.

En particulier, l'invention s'applique particulièrement dans le cas où d'une part le transistor est alimenté en entrée par un signal à très haute fréquence, et d'autre part le transistor travaille dans des conditions où la température de fonctionnement ambiante peut changer très profondément.

Ceci est le cas quand on utilise un tel transistor dans des circuits électroniques embarqués à bord d'un satellite artificiel qui est mis en rotation sur lui-même et peut être à quelques minutes de distance éclairé par le flux lumineux solaire d'une part, et dans la zone d'ombre, quelques instants plus tard, d'autre part. Ceci est aussi le cas quand on dispose du transistor dans des circuits embarqué à bord d'une automobile par exemple, proche du compartiment thermique du moteur dans lequel la température peut passer en quelques instants de 20°C à 150° quand le moteur a fonctionné un long moment.

A cet effet, la présente invention concerne aussi un circuit intégré intégrant un transistor bipolaire à hétérojonction doté d'un dispositif interne de stabilisation.

La présente invention sera mieux comprise à l'aide de la description annexée, et des figures qui sont :

la figure 1, un moyen connu de stabilisation des processus de divergence thermique dans le cas d'un transistor à homojonction ;
Les figures 2a à 2d, quatre dispositifs selon l'invention pour stabiliser le comportement thermique d'un transistor à hétérojonction ;
La figure 3, un mode de réalisation d'un transistor à hétérojonction interdigité ;
La figure 4, un graphe montrant la relation entre le courant de collecteur et la tension base- émetteur dans deux transistors à hétérojonction, l'un selon l'art antérieur, l'autre muni du dispositif de stabilisation de l'invention ;
Les figures 5 et 6, une vue en coupe et une vue de face d'un mode de réalisation de l'invention.

A la figure 1, on a représenté un transistor à homojonction interdigité constitué par plusieurs doigts de base et d'émetteur. Sur un substrat 1a, 1b, 1c, ... 1n, on dispose une ligne commune de collecteur et n chemins base-émetteur reliant la ligne commune de collecteur à une ligne commune d'émetteur. Pour faire converger vers une valeur stable les phénomènes d'augmentation du courant d'émetteur, en fonction de la température ambiante, on sait disposer dans le chemin d'émetteur, par exemple sur le doigt d'émetteur de chaque jonction, une résistance 2a, 2b, 2c ... 2d.

Un tel dispositif est thermiquement stable, mais son fonctionnement est affecté par la variation de la température ambiante.

Aux figures 2a et 2b, on a représenté quatre modes de réalisation d'un dispositif de stabilisation selon l'invention particulièrement adaptés à un transistor à hétérojonction à base fortement dopée et utilisés pour des applications à très haute fréquence. Pour les besoins de l'invention, on distingue une source en courant continu DC et une source de signal en fréquence RF. Cette façon de connecter le transistor permet de distinguer et de protéger le signal de la polarisation. Ainsi, sur les figures 2b et 2c on dispose sur la base 6 du transistor à hétérojonction d'une part, un condensateur 4, qui relie la base à la source haute fréquence RF, et d'autre part, une résistance 5 qui relie la base à la source de polarisation continue DC.

Dans les quatre modes de réalisation des figures 2a à 2d, chaque transistor à hétérojonction est fabriqué sur un substrat ou zone active ZA et est associé à un dispositif de stabilisation. Ce substrat ou zone active peut être prévu pour implanter les seules jonctions du transistor. Mais, il peut être divisé par des caissons d'isolement de façon à constituer un circuit intégré complexe. De même, certaines des fonctions de l'invention peuvent être réalisées par des surfaces directement liées à la zone active ZA comme la réalisation d'une résistance de stabilisation, ou lui être extérieur en tout ou partie. Les mêmes références au dessin sont utilisées pour des parties identiques.

A la figure 2a, la base du transistor 6 est connectée à la source de signal et de polarisation unique DC et RF par un dispositif de stabilisation qui comporte une simple résistance 5. Une première extrêmité de la résistance est connectée à la fois à la source de signal RF et à la source de tension électrique DC de polarisation en courant continu, tension continue qui fixe le point de fonctionnement du transistor.

La zone active ZA du transistor 6 se limite à la réalisation des jonctions du transistor. Le schéma peut être adopté aussi pour un circuit intégré complexe.

A la figure 2b, le transistor 6 est implémenté sur une zone active ZA. Le dispositif de stabilisation thermique comporte deux accès séparés : le premier destiné à recevoir la tension continue DC de polarisation du transistor, le second destiné à recevoir le signal d'entrée, par exemple à très haute fréquence RF. Le dispositif de stabilisation comporte ici une résistance 5 et un condensateur 4 dont les bornes communes sont connectées à un chemin conducteur de base. Cette disposition à l'extérieur de la zone active ZA présente l'avantage de permettre de ne pas charger le dessin (ou topogramme) du circuit intégré, ou encore de ne pas influencer au point de vue thermique ou par des parasites le reste du transistor. Un autre avantage est de permettre de fabriquer un condensateur de forte valeur sans pénaliser le facteur de forme du transistor ou du reste du circuit intégré disposé sur la zone active ZA.

A la figure 2c, la zone active ZA porte à la fois le transistor 6 et son dispositif de stabilisation 4, 5. Une telle disposition permet d'intégrer directement le dispositif de stabilisation au plus près de la zone de dérive en température. Le dispositif de stabilisation est semblable à celui de la figure 2b, sauf que le condensateur 4 ne peut pas être, sans pénaliser la densité d'intégration, aussi important que dans le cas précédent.

A la figure 2d, on a représenté un mode de réalisation dans lequel le dispositif de stabilisation comporte une résistance 5 reliée à la tension continue DC de polarisation depuis l'intérieur de la zone active (ou du substrat) ZA. Par contre, le condensateur est extérieur à cette zone active. Cette disposition permet de combiner les avantages de l'intégration du dispositif de stabilisation avec ceux d'un condensateur de forte valeur.

Le principe de fonctionnement du transistor de l'invention peut être expliqué comme suit.

En mettant une résistance de stabilisation de valeur très grande en série sur la base, la base du transistor est polarisée par une source de courant. De ce fait, quand la température extérieure de fonctionnement augmente, comme le gain en courant $\beta$ diminue le courant de collecteur diminue. Au contraire, en mettant une résistance de stabilisation de valeur très faible, voisine de 0, la base du transistor est polarisée par une source de tension. De ce fait, quand la température extérieure de fonctionnement augmente, le courant de collecteur augmente. Entre ces deux extrêmes, en mettant une résistance de valeur intermédiaire, on peut donc avoir une indépendance du courant de collecteur par rapport à la température de fonctionnement.

En définissant xtb comme une grandeur qui dépend du gain en courant $\beta$ et de la température de jonction de la forme :

$$xtb = -d(\log \beta)/d(\log(Tj)) \qquad (7)$$

On a trouvé que dans ce cas, la résistance de stabilisation qu'il faut placer sur la base pour obtenir la stabilité thermique est donnée par une expression de la forme :

$$Rb = Tj. f(dEg/dTj, Iso, Ic, \beta, xtb) \qquad (8)$$

où dEg/dTj est la dérivée partielle par rapport à la température de jonction Tj de l'énergie propre Eg de la jonction émetteur - collecteur et où f est une fonction de modélisation du transistor.

Dans un mode de réalisation, la résistance de stabilisation est égale à :

$$Rb = \beta.Tj (dEg/dTj + k.\ln(Iso) - k.\ln(Ic))/xtb.Ic \qquad (9)$$

où k est la constante de Boltzmann et Iso le courant de saturation du collecteur multiplié par exp(Eg/300k).

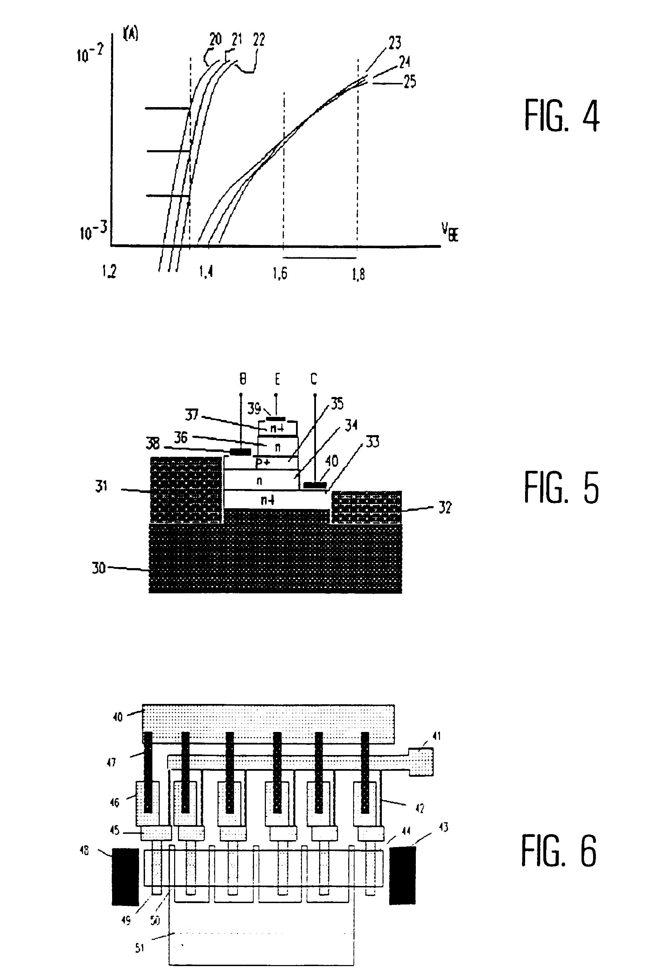

A la figure 4, on a représenté le graphe du courant de collecteur Ic en fonction de la tension base- émetteur Vbe. Les courbes 20, 21 et 22 correspondent aux courbes d'un transistor de la figure 3 qui ne comporte pas de dispositif de stabilisation thermique 8a, 8b, ..., 8n. Ces trois courbes sont mesurées respectivement à des températures de -20°C, 0°C, et +20°C.

A la figure 4, on a aussi représenté trois courbes 23, 24, 25 correspondantes au même transistor de la figure 3, mais muni de son dispositif de stabilisation thermique 8a, 8b, ..., 8n. Ces courbes 23, 24, 25 sont obtenues aussi aux températures de -20°C, 0°C et 20°C, respectivement.

On remarque que pour le transistor à hétérojonction monté avec un dispositif de stabilisation selon l'invention, et pour $V_{BE}$ compris entre 1,6 et 1,8 volts, Ic reste indépendant de la température ambiante Ic. A la différence, pour le transistor bipolaire à hétérojonction sans dispositif de stabilisation, Ic change pour une valeur donnée de la tension base- émetteur VBE.

D'une manière générale, le moyen de l'invention est constitué pour un transistor bipolaire à hétérojonction par une résistance de stabilisation connectée à la base à travers laquelle on alimente le transistor en continu et parallèlement par une capacité de découplage, connectée elle aussi à la base. La valeur de la résistance de stabilisation est choisie de manière telle que les caractéristiques du transistor sont indépendantes de la température extérieure. La valeur de la capacité est choisie de sorte que le signal RF en fréquence ne soit ni atténué par cette capacité, ni perturbé par la résistance de stabilisation.

Dans certains cas, la valeur de la capacité entraîne que la surface occupée par le condensateur intégré sur la zone active, ou le même substrat que le transistor bipolaire à hétérojonction proprement dit, devient prohibitive pour le facteur de forme du circuit intégré ou encore qu'elle devient irréalisable. Dans un tel cas, il est possible de fabriquer le dispositif de stabilisation sur un autre substrat ou à l'extérieur du transistor bipolaire à hétérojonction proprement dit.

A la figure 3, on a représenté un mode de réalisation d'un transistor à hétérojonction interdigité muni du dispositif de stabilisation de l'invention. Deux lignes de collecteur 11 et d'émetteur 12 permettent de connecter convenablement la zone de collecteur et les zones d'émetteur, sur un substrat 7a, 7b, ... 7n. Les doigts de base de chacune des zones de substrat 7a, 7b... 7n sont reliés à un circuit selon le montage de la figure 2. Ainsi, chaque chemin collecteur- émetteur 7a, 7b... 7n est polarisé par un montage entre une ligne de polarisation de base DC par une résistance 9a. Il est d'autre part connecté à une ligne de signal haute fréquence RF par un condensateur 10a. On a ainsi une suite 8a, 8b, ... 8n de dispositifs de stabilisation thermique, répartis sur chaque doigt de base. La base est constituée par deux lignes parallèles 13 et 14.

A la figure 5 et à la figure 6, on a représenté une coupe et une vue de dessus d'un transistor bipolaire à hétérojonction muni du dispositif de stabilisation de l'invention.

Le dopage typique de la base du dispositif est sous une concentration en impuretés de 5 $10^{19}$ Atomes/cm$^3$ avec une épaisseur de 900 Angströms (90nm).

Le substrat 30 reçoit, par exemple par épitaxie, une succession de couches de matériaux semi conducteurs des groupes III-V, couches qui sont : la couche 33 dopée N+, la couche 34 dopée N, la couche 35 dopée P+, la couche 36 dopée N et la couche 37 dopée N+. La couche 33 est, dans la vue de la figure 5 de largeur plus grande que les couches 34 à 37. La plage supérieure est destinée à recevoir un contact métallique 40 de collecteur.

Les deux couches 34 et 35 dopées N et P+ sont elles-mêmes de surfaces réduites, de façon à disposer d'une plage libre supérieure sur laquelle on réalise un contact 38 de base. Les couches 36 et 37 sont de surfaces encore plus petites, suffisantes pour pratiquer sur la face de dessus un contact métallique 39 d'émetteur.

D'autre part, la zone active du transistor est encadrée par deux caissons d'isolement 31 et 32 qui permettent de l'isoler du reste du circuit intégré.

A la figure 6, on a représenté une vue de dessus du transistor de la figure 5 dans une structure interdigitée de puissance, stabilisé par le moyen de l'invention. Le transistor de la figure 6 comporte deux lignes parallèles de base 40 et 41. La ligne 40 est une ligne d'accès en fréquence qui correspond à l'accès RF de la figure 3. La ligne 41 est une ligne d'accès de polarisation continue qui correspond à l'entrée DC de ligne de base de la figure 3.

Sur la zone active 44, on dispose une pluralité de doigts de base comme le doigt 49. Chaque doigt de base 49 est connecté par un dispositif de stabilisation, comprenant une résistance de stabilisation et un condensateur de stabilisation. Le condensateur de stabilisation est constitué par une zone 46 sur le circuit intégré, tandis que la résistance de stabilisation est constituée par une zone 42. La zone 47 relie le doigt de base 49 à la ligne 40 . La zone 42 est reliée au doigt de base par une zone 45 et à la ligne 41.

D'autre part, entre les doigts de base comme le doigt 49, on a disposé des doigts d'émetteur 50 reliés à une ligne commune d'émetteur 51.

En choisissant une valeur de capacité de liaison de 50 fF par exemple et une résistance de polarisation 42 de valeur de 500 Ohms par exemple, en fonctionnement en polarisation en émetteur commun, l'émetteur est à la masse et le collecteur est à une tension bien définie. La base est polarisée par une tension appliquée sur les résistances comme la résistance 42. Le signal à amplifier entre dans la structure par la ligne 40 sur la capacité 46, et le signal de sortie sera produit au collecteur. Ce transistor interdigité est stabilisé et fonctionne à sa vitesse maximale indépendamment de la température ambiante.

## Revendications

1. Transistor bipolaire à hétérojonction (6), caractérisé en ce qu'il comporte un dispositif de stabilisation thermique, destiné à affranchir le transistor des variations de la température extérieure, qui comporte au moins une résistance (5), de valeur $R_b$, connectée sur le chemin de base du transistor bipolaire à hétérojonction entre une source de polarisation continue (DC) et la base, la résistance (5) du dispositif de stabilisation -étant déterminée par la relation suivante :

$$R_b = \beta . Tj(dEg/dTj + k.ln(Is0) - k.ln(Ic))/xtb.Ic$$

où $\beta$ est le gain en courant du transistor, Tj est la température de jonction stabilisée, dEg/dTj est la dérivée partielle par rapport à la température de jonction Tj de l'éneregie propre Eg de la jonction émetteur-collecteur, k est la constante de Boltzmann, Is0 est un paramètre caractéristique du courant de sortie du transistor, Ic est la valeur du courant de polarisation du transistor et xtb = - d(logβ)/d(log(Tj)).

2. Transistor bipolaire à hétérojonction selon la revendication 1, caractérisé en ce que le dispositif de stabilisation comporte au moins un condensateur (4) dont une borne est connectée au point commun entre la résistance (5) et le chemin de base, dont l'autre borne est connectée à une entrée (RF) d'un signal hyperfréquence, et en ce que la seconde extrémité libre de la résistance est connectée à une entrée de polarisation en continu du transistor.

3. Transistor selon la revendication 1 ou 2, caractérisé en ce que le dispositif de stabilisation (4, 5 ; 5) et le transistor proprement dit sont réalisés directement de manière monolithique.

4. Transistor selon la revendication 1 ou 2, caractérisé en ce que le dispositif de stabilisation (4, 5 ; 5) est réalisé à l'extérieur du transistor proprement dit.

5. Transistor selon la revendication 2, caractérisé en ce que la valeur de la capacité du dispositif de stabilisation (4, 5) est choisie de sorte que le signal en fréquence ne soit ni atténué par cette capacité ni perturbé par la résistance de stabilisation.

6. Transistor selon l'une des revendications précédentes, caractérisé en ce qu'il est du type interdigité, et en ce qu'il comporte une pluralité de doigts de base (7a, 7b,..., 7n), chacun étant relié à la polarisation et au signal d'entrée par un dispositif de stabilisation (8a, 8b, ..., 8n), comportant en parallèle une résistance (9a, 9b, ..., 9n) de stabilisation reliant le doigt de base à une ligne commune de polarisation continue (13) et un condensateur (10a, 10b, ..., 10n) reliant le doigt de base à une ligne commune (14) d'accès du signal d'entrée en fréquence.

7. Transistor selon la revendication 6, caractérisé en ce que le condensateur du dispositif de stabilisation est constitué par une première zone (46) reliée à une zone commune (40) d'entrée de signal en fréquence tandis que la résistance de stabilisation est constituée par une zone (42) reliée au doigt de base et à une ligne commune (41) de polarisation en courant continu.

8. Circuit intégré, caractérisé en ce qu'il comporte au moins un transistor bipolaire à hétérojonction doté d'au moins un dispositif de stabilisation selon l'une des revendications précédentes.

## Claims

1. Heterojunction bipolar transistor (6), characterized in that it includes a thermal stabilizing device intended to free the transistor from variations in the outside temperature, which includes at least one resistor (5), of value $R_b$, connected in the base path of the heterojunction bipolar transistor between a dc bias source (DC) and the base, the resistor (5) of the stabilizing device being determined by the following relation:

$$R_b = \beta.Tj(dEg/dTj \div k.\ln(Is0)-k.\ln(Ic))/xtb.Ic$$

where β is the current-gain of the transistor, Tj is the stabilized junction temperature, dEg/dTj is the partial derivative with respect to the junction temperature Tj of the characteristic energy Eg of the emitter-collector junction, k is Boltzmann's constant, IsO is a parameter characteristic of the output current of the transistor, Ic is the value of the bias current of the transistor and

$$xtb = - d(\log \beta)/d(\log(Tj)).$$

2. Heterojunction bipolar transistor according to Claim 1, characterized in that the stabilizing device includes at least one capacitor (4), a terminal of which is connected to the common point between the resistor (5) and the base path, the other terminal of which is connected to an input (RF) for a microwave signal, and in that the second free end of the resistor is connected to a dc bias input of the transistor.

3. Transistor according to Claim 1 or 2, characterized in that the stabilizing device (4, 5; 5) and the transistor proper are constructed directly in a monolithic manner.

4. Transistor according to Claim 1 or 2, characterized in that the stabilizing device (4, 5; 5) is constructed outside the transistor proper.

5. Transistor according to Claim 2, characterized in that the value of the capacitance of the stabilizing device (4, 5) is chosen such that the frequency signal is neither attenuated by this capacitance nor perturbed by the stabilizing resistor.

6. Transistor according to one of the preceding claims, characterized in that it is of the interdigitated type, and in that it includes a plurality of base fingers (7a, 7b ..., 7n), each being linked with the bias and with the input signal by a stabilizing device (8a, 8b, ..., 8n), including in parallel a stabilizing resistor (9a, 9b, ..., 9n) linking the base finger to a common dc bias line (13) and a capacitor (10a, 10b, ..., 10n) linking the base finger to a common line (14) for access for the frequency input signal.

7. Transistor according to Claim 6, characterized in that the capacitor of the stabilizing device consists of a first zone (46) linked to a common zone (40) for frequency signal input whilst the stabilizing resistor consists of a zone (42) linked to the base finger and to a common dc current bias line (41).

8. Integrated circuit, characterized in that it includes at least one heterojunction bipolar transistor furnished with at least one stabilizing device according to one of the preceding claims.

## Patentansprüche

1. Heteroübergang-Bipolartransistor (6), **dadurch gekennzeichnet**, daß er eine Wärmestabilisierungseinrichtung umfaßt, die den Transistor frei macht von Veränderungen der Außentemperatur und die wenigstens einen Widerstand (5) mit dem Wert $R_b$ umfaßt, eingeschaltet in dem Strompfad zwischen der Basis des Heteroübergang-Bipolartransitors und einer Gleichstrom-Vorspannungsquelle (DC), wobei der Widerstand (5) der Stabilisierungseinrichtung bestimmt wird durch die folgende Relation:

$$R_b = \beta.Tj(dEg/dTj+k.\ln(Is0))-k.\ln(Ic))/xtb.Ic$$

wobei β die Stromverstärkung des Transistors ist, Tj die stabilisierte Übergangstemperatur, dEg/dTj das partielle Differential in bezug auf die Übergangstemperatur Tj der Eigenenergie Eg des Emitter-Kollektor-Übergangs, k die Boltzmannkonstante, Is0 ein für den Ausgangsstrom des Transistors charakteristischer Parameter, Ic der Wert des Vorspannungsstroms des Transistors und

$$xtb = -d(\log \beta)/d(\log(Tj))$$

ist.

2. Heteroübergang-Bipolartransistor nach Anspruch 1, dadurch gekennzeichnet, daß die Stabilisierungseinrichtung wenigstens einen Kondensator (4) umfaßt, dessen einer Anschluß verbunden ist mit dem gemeinsamen Punkt zwischen dem Widerstand (5) und dem Basisstrompfad, und dessen anderer Anschluß verbunden ist mit einem Eingang (RF) eines Ultrahochfrequenzsignals, und dadurch, daß das zweite freie Ende des Widerstands verbunden ist mit einem Gleichstrom-Vorspannungseingang des Transistors.

3. Transistor nach Anspruch 1 oder 2, dadurch gekennzeichnet, daß die Stabilisierungseinrichtung (4, 5; 5) und der eigentliche Transistor direkt auf monolithische Weise hergestellt werden.

4. Transistor nach Anspruch 1 oder 2, dadurch gekennzeichnet, daß die Stabilisierungseinrichtung (4, 5; 5) außerhalb des eigentlichen Transistors realisiert wird.

5. Transistor nach Anspruch 2, dadurch gekennzeichnet, daß der Wert der Kapazität der Stabilisierungseinrichtung (4, 5) so gewählt wird, daß das Frequenzsignal weder durch diese Kapazität geschwächt noch durch den Stabilisierungswiderstand gestört wird.

6. Transistor nach einem der vorangehenden Ansprüche, dadurch gekennzeichnet, daß er vom Interdigitations- bzw. Parallelschaltungstyp ist, und dadurch, daß er eine Vielzahl Basisfinger (7a, 7b, ..., 7n) umfaßt, jeder verbunden mit der Vorspannung und dem Eingangssignal über eine Stabilisierungseinrichtung (8a, 8b, ..., 8n), in Parallelschaltung einen den Basisfinger mit einer gemeinsamen Gleichstrom-Vorspannungsleitung (13) verbindenden Stabilisierungswiderstand (9a, 9b,..., 9n) und einen Kondensator (10a, 10b, ..., 10n) umfassend, der den Basisfinger mit einer gemeinsamen Eingangsfrequenzsignal-Anschlußleitung (14) verbindet.

7. Transistor nach Anspruch 6, dadurch gekennzeichnet, daß der Kondensator der Stabilisierungseinrichtung gebildet wird durch eine erste Zone (46), verbunden mit einer gemeinsamen Frequenz-signal-Eingangszone (40), während der Stabilisierungswiderstand gebildet wird durch eine durch eine Zone (42), verbunden mit dem Basisfinger und mit einer gemeinsamen Gleichstrom-Vorspannungsleitung (41).

8. Integrierte Schaltung, dadurch gekennzeichnet, daß sie wenigstens einen Heteroübergang-Bipolartransistor umfaßt, versehen mit wenigstens einer Stabilisierungseinrichtung nach einem der vorangehenden Ansprüche.

FIG. 1

FIG. 2a

FIG. 2b

FIG. 2d

FIG. 2c

FIG. 3

FIG. 4

FIG. 5

FIG. 6